Europäisches Patentamt

European Patent Office

Office européen des brevets

(11) Publication number: **0 049 640**
**B1**

## EUROPEAN PATENT SPECIFICATION

(45) Date of publication of patent specification: **22.05.85**

(21) Application number: **81304662.0**

(22) Date of filing: **07.10.81**

(51) Int. Cl.⁴: **H 03 K 5/02**

(54) A line driver circuit.

(30) Priority: **08.10.80 JP 141038/80**

(43) Date of publication of application:
**14.04.82 Bulletin 82/15**

(45) Publication of the grant of the patent:
**22.05.85 Bulletin 85/21**

(84) Designated Contracting States:
**DE FR GB NL**

(56) References cited:
**FR-A-2 093 680**
**US-A-3 700 922**

**IBM TECHNICAL DISCLOSURE BULLETIN, vol.
15, no. 1, June 1972, pages 41-42, New York,
U.S.A. A.A. HANSEN et al.: "Bipolar driver for
interfacing bipolar and fet circuits"**
**IBM TECHNICAL DISCLOSURE BULLETIN, vol.
15, no. 1, June 1972, page 256, New York, USA
H. GELLER et al.: "Darlington pulldown clamp"**

(73) Proprietor: **FUJITSU LIMITED**
**1015, Kamikodanaka Nakahara-ku
Kawasaki-shi Kanagawa 211 (JP)**

(72) Inventor: **Sumi, Hideji
488-2-1-301 Sugeta-cho
Kanagawa-ku Yokohama-shi Kanagawa 221 (JP)**
Inventor: **Kokado, Masayuki
5-16-1-405 Masugata
Tama-ku Kawasaki-shi Kanagawa 214 (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

The present invention relates to a line driver circuit including an emitter follower output stage.

A line driver circuit is used, for example, to transmit signals from a terminal unit, through a transmission line to a remote unit such as a computer. The transmission line may have a length of several tens of metres or several hundreds of metres. The output stage of the line driver circuit includes transistors connected in an emitter follower configuration. To transmit signals over such a long distance, the line driver circuit has to have a large driving capacity. Therefore, the transistors in the emitter follower stage must have a large capacity. The fall time of the output signal from the emitter follower stage is long in comparison with that of other transistor logic circuits. When the size of the transistors in the emitter follower is increased, the capacitance of the base and the emitter of the transistors is also increased and, accordingly, the fall time of the output signal is further increased, resulting in the difficulty of obtaining high-speed operation leading to a disadvantage in conventional line driver circuits.

US—A—3700922 discloses a line driver circuit comprising a differential amplifier having a first transistor for receiving an input signal and a second transistor for receiving a reference signal, the first and second transistors being exclusively turned on and off in response to the potential of the input signal, an output stage having transistors connected in an emitter follower configuration in which the output-stage transistor provides an output signal of a high potential or a low potential in response to the output potential of the differential amplifier and a discharge path for drawing charges accumulated on the base of the output-stage transistor in the emitter follower when the output-stage transistor in the emitter follower changes its stage from ON to OFF.

According to this invention such a line driver circuit has the discharge path connected between the base of the output-stage transistor and the collector of one of the transistors in the differential amplifier, and a current switch coupled to the discharge path for cutting off the discharge path when the voltage between the base and the emitter of the output-stage transistor is equal to or lower than the threshold voltage for turning on the output-stage transistor.

An advantage of the present invention is that discharge through the discharge path only takes place during the transition period in which the output signal changes from its high to its low level, so that the output waveform is not distorted in its normal state. This results in the line driver circuit in accordance with this invention being able to drive a computer a long distance away at high speed.

An example of a line driver circuit in accordance with this invention will now be described and contrasted with the prior art and other proposals with reference to the accompanying drawings; in which:—

Figure 1 is a circuit diagram of a conventional line driver circuit;

Figure 2 is a circuit diagram of a proposal for a line driver circuit;

Figure 3 is a graph illustrating the fall time characteristics of the line driver circuits shown in Figure 1 and 2;

Figure 4 is a circuit diagram of a transmission system using a line driver circuit; and,

Figure 5 is a circuit diagram of an example of a line driver circuit in accordance with the present invention.

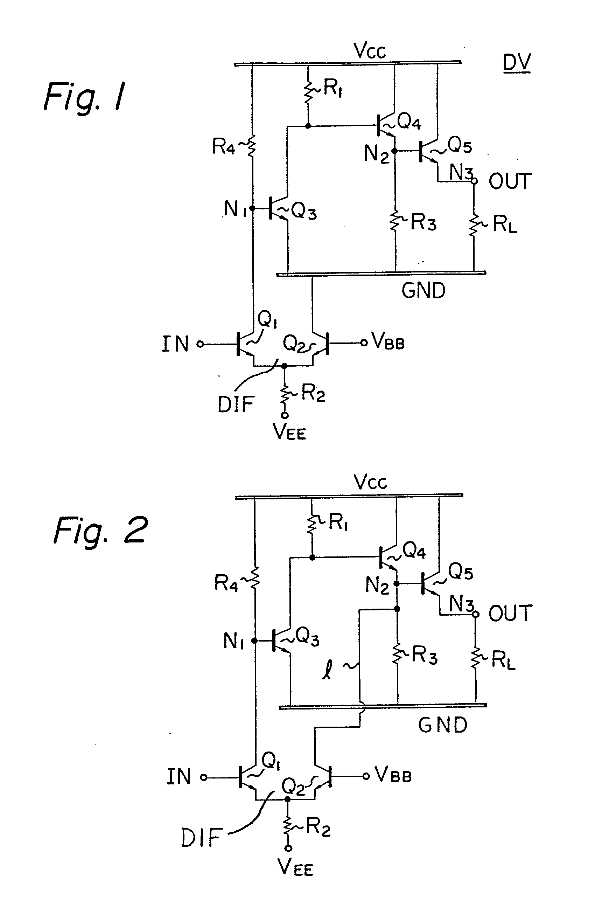

Referring to Figures 1 and 2, a line driver circuit DV of a level-converting type for converting an ECL level to a TTL level is illustrated. An input terminal IN receives an input signal which has two values, i.e. a high potential (hereinafter referred to as an H level) of zero volts (ground level) and a low potential (hereinafter referred to as an L level) of a negative voltage $V_{EE}$. The input terminal IN is connected to the base of a first transistor Q1. The base of a second transistor Q2 is connected to a reference terminal for receiving a reference voltage $V_{BB}$ which has a value between the H level and the L level. The collector of the first transistor Q1 is connected through a pull-up resistor R4 to a power supply line $V_{CC}$. The first transistor Q1, the second transistor Q2, and the resistor R2 constitute a differential amplifier DIF. When the input terminal IN receives an input signal of the H level, the first transistor Q1 is switched on and the second transistor Q2 is switched off. When the input terminal IN receives an input signal of the L level, the first transistor Q1 is switched off and the second transistor Q2 is switched on.

The collector of the first transistor Q1 is also connected to the base of a transistor Q3. The collector of the transistor Q3 is connected through a pull-up resistor R1 to the power supply line $V_{CC}$ and is also connected to the base of a transistor Q4. The emitter of the transistor Q3 is connected to the ground line GND. The collector of the transistor Q4 is connected to the power supply line $V_{CC}$. The emitter of the transistor Q4 is connected to the base of a transistor Q5. The base of the transistor Q5 is connected through a pull-down resistor R3 to the ground line GND. The collector of the transistor Q5 is connected to the power supply $V_{CC}$. The emitter of the transistor Q5 is connected to the output terminal OUT. Between the output terminal OUT and the ground line GND, a load resistor $R_L$ is connected. Thus the transistors Q4 and Q5 are connected together in an emitter follower configuration. The transistor Q3 drives the emitter follower in response to the potential at the collector of the first transistor Q1, i.e. at a node N1. These transistors Q3 and Q5 are operated by the positive power supply $V_{CC}$.

In the conventional arrangement shown in Figure 1, the collector of the second transistor Q2 is connected to the ground line GND. In a proposal shown in Figure 2, the collector of the second transistor Q2 is connected through a discharge path l to the base of the transistor Q5.

The operation of such a proposed circuit shown in Figure 2 will now be explained. When the input terminal IN receives an input signal of the H level, the potential at the collector of the transistor Q1 is the L level so that the transistor Q3 is in an OFF state, and accordingly the transistor Q4 is in an ON state because its base receives current from the power supply line $V_{CC}$ through the pull-up resistor R1, resulting in the H level at the emitter of the transistor Q4, i.e. at the node N2. Therefore, the output-stage transistor Q5 is turned on so that the potential at the output terminal OUT connected to the emitter of the transistor Q5 becomes the H level. In contrast, when the input terminal IN receives an input signal of the L level, the transistor Q1 is turned off so that the potential at the base of the transistor Q3, i.e. at the node N1, is pulled up to the H level by the resistor R4, resulting in the transistor Q3 being turned on. As a result, the potential at the base of the transistor Q4 becomes the L level so that the potential at the nodes N2 and N3 becomes the L level.

To make the potential at the output terminal OUT the L level, the potential at the base of the transistor Q5, i.e. at the node N2, must be turned to the L level. In the conventional circuit when the potential at the input terminal IN changes from the H level to the L level that is, when the transistor Q5 switches from ON to OFF, charges on the base of the transistor Q5 are drawn through a path, including the node N2 and the pull-down resistor R3, to the ground line GND. Due to the pull-down resistor R3, the discharge time constant is so large that the fall time of the potential at the output terminal OUT is too long.

In contrast, with the example shown in Figure 2, the base of the transistor Q5 is connected through the discharge path l to the collector of the second transistor Q2. By this connection when the potential at the input terminal IN charges from the H level to the L level, charges on the base of the transistor Q5 are rapidly drawn through the discharge path l, the second transistor Q2 which is in an ON state at this time, and the resistor R2 to the negative voltage source $V_{EE}$. Therefore, the fall time of the potential at the output terminal OUT would be decreased in comparison with the convention circuit.

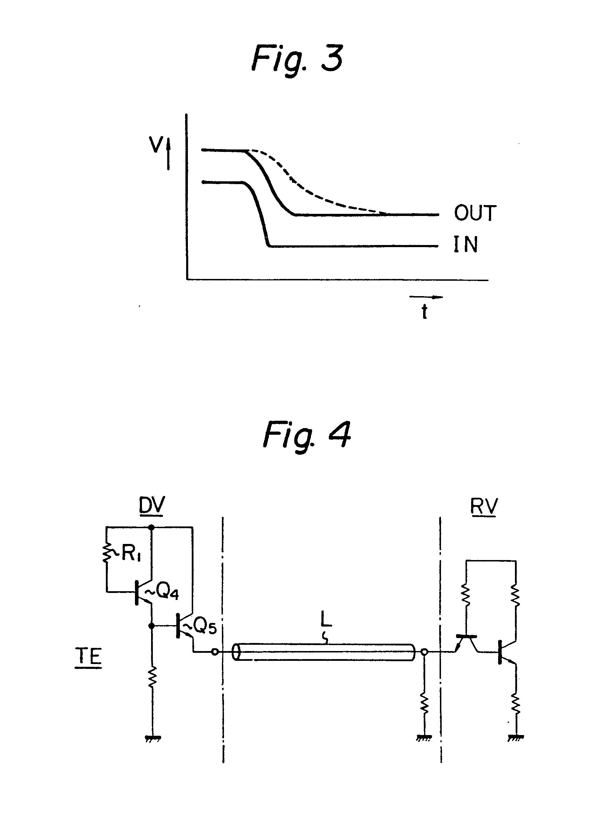

Figure 3 is a graph illustrating the fall time characteristics of the line driver circuits of Figures 1 and 2. In Figure 3, the output waveform of the conventional circuit is shown by a dotted line and of the circuit of this invention by a solid line. Figure 3 clearly illustrates the more rapid fall of the output signal compared with that of the conventional output signal in response to a fall in the input signal.

Figure 4 illustrates a system using a line driver circuit and TE is a terminal unit having at its output stage the line driver circuit DV; RV is a receiver circuit in, for example, a computer; and L is a transmission line connected between the line driver circuit and the receiver circuit. Only the emitter follower in the line driver circuit DV is illustrated. The length of the transmission line L is from several tens of metres to several thousands of metres. The line driver circuit is formed as an integrated circuit.

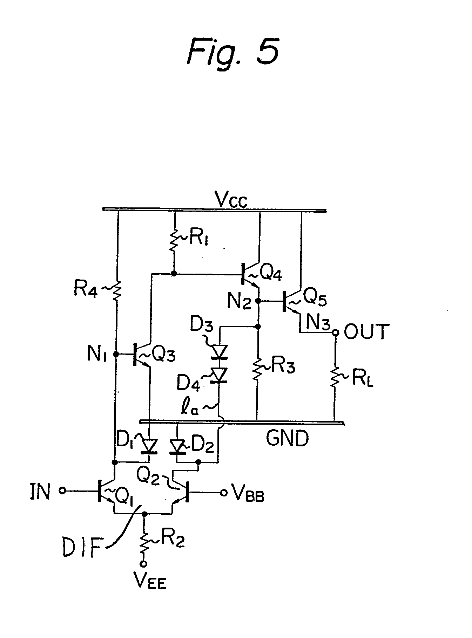

A practical example of a line driver in accordance with this invention is shown in Figure 5. The difference between this and the proposal in Figure 2 is the addition of four diodes D1 to D4. The anode of the diode D1 is connected to the ground line GND. The cathode of the diode D1 is connected to the collector of the first transistor Q1. The diode D1 acts to prevent the transistor Q1 from being saturated. The anode of the diode D2 is connected to the ground line GND. The cathode of the diode D2 is connected to the collector of the second transistor Q2. In place of the discharge path l in the Figure 2 proposal the two diodes D3 and D4 are connected in series in a discharge path la extending between the base of the transistor Q5 and the collector of the transistor Q2. The two diodes D3 and D4 constitute a discharge path for drawing charges on the base of the transistor Q5 when the potential at the node N2 falls. The diode D2 and the two diodes D3 and D4 together form a current switch. In operation, when the potential at the input terminal begins to fall from the H level to the L level, the first transistor Q1 is turned off and the second transistor Q2 is turned on. Then, the transistor Q3 is turned on and the transistors Q4 and Q5 are turned off. Therefore, the potential at the node N2 begins to fall. During this time, charges on the base of the transistor Q5 are rapidly drawn through a discharge path la including the two diodes D3 and D4, the second transistor Q2 which is in an ON state, and the resistor R2 to the negative voltage source $V_{EE}$, as well as through the pull-down resistor R3 to the ground line GND, so that the potential at the output terminal OUT falls more rapidly in comparison with the conventional circuit. When the potential at the node N2 reaches $V_{BE}$, where $V_{BE}$ represents the base-emitter voltage of the transistor Q5 and the forward voltage of the diode D2, D3 or D4, the potential at the output terminal OUT becomes zero volts, and the two diodes D3 and D4 are cut off. Therefore, when the potential at the node N2 is lower than $V_{BE}$, charge is not drawn from the base of the transistor Q5. When the potential at the input terminal IN is the H level, the second transistor Q2 is at an off state so that again charge is not drawn. Thus, a charge is drawn through the two diodes D3 and D4 only when the potential at the base of the transistor Q5, i.e., at the node N2, is lower than the H level but is higher than $V_{BE}$. As a result, according to the invention, in a normal state in which the potential at the output terminal OUT is the H level or the L level, no current is conducted through the two diodes D3 and D4 so that the output waveform is not distorted.

In accordance with the present invention, a rapid discharge path is connected to the base of the transistor connected in an emitter follower configuration in the output stage of the line driver circuit and this decreases the fall time of the output waveform, even when the size of the transistors in the emitter follower is greater to improve its driving capacity. Also since a current switch is present in the discharge path, discharge is effected only during the transition period from the H level to the L level of the output signal, so that the output waveform is not affected in its normal state. As a result, such a line driver can be used to drive a computer a long distance away at high speed.

## Claims

1. A line driver circuit comprising a differential amplifier (DIF) having a first transistor (Q1) for receiving an input signal and a second transistor (Q2) for receiving a reference signal, the first and second transistors being exclusively turned on and off in response to the potential of the input signal, an output stage having transistors (Q4 and Q5) connected in an emitter follower configuration in which the output-stage transistor (Q5) provides an output signal of a high potential or a low potential in response to the output potential of the differential amplifier (DIF), and a discharge path (I, Ia) for drawing charges accumulated on the base of the output stage transistor (Q5) in the emitter follower when the output-stage transistor (Q5) in the emitter follower changes its state from ON to OFF, characterised in that the discharge path (I, Ia) is connected between the base of the output-stage transistor (Q5) and the collector of one of the transistors (Q2) in the differential amplifier (DIF) and in that a current switch (D2, D3, D4) is coupled to the discharge path (Ia), for cutting off the discharge path (Ia) when the voltage between the base and the emitter of the output-stage transistor (Q5) is equal to or lower than the threshold voltage for turning on the output-stage transistor (Q5) (Figure 5).

2. A line driver circuit according to claim 1, wherein the current switch comprises two diodes (D3 and D4) connected in series in the discharge path (Ia) and one diode (D2) connected between a ground line and the collector of the said one of the transistors (Q2) in the differential amplifier (DIF).

3. A line driver circuit according to claim 1 or 2, wherein the line driver circuit also includes a driving transistor (Q3) for driving the emitter follower (Q4, Q5) in response to the turning on or off of the other of the transistors (Q1) of the differential amplifier (DIF).

4. A line driver circuit according to claim 3, wherein the said one of the transistors of the differential amplifier (DIF) is the second transistor (Q2) and the said other of the transistors of the differential amplifier is the first transistor (Q1).

## Patentansprüche

1. Leitungstreiberschaltung mit einem Differentialverstärker (DIF), der einen ersten Transistor (Q1) zum Empfang eines Eingangssignals und einen zweiten Transistor (Q2) zum Empfang eines Referenzsignals umfaßt, wobei der erste und der zweite Transistor ausschließlich in Abhängigkeit von dem Potential des Eingangssignals ein- und ausgeschaltet werden, mit einer Ausgangsstufe, welche Transistoren (Q4 und Q5) umfaßt, die in einer Emitterfolgeschaltung verbunden sind, in welcher der Ausgangsstufentransistor (Q5) ein Ausgangssignal mit einem hohen Potential oder einem niedrigen Potential in Abhängigkeit von dem Ausgangspotential des Differentialverstärkers (DIF) liefert, und mit einem Entladungsweg (I, Ia), um Ladungen zu ziehen, welche auf der Basis des Ausgangsstufentransistors (Q5) in der Emitterfolgeschaltung akkumuliert sind, wenn der Ausgangsstufentransistor (Q5) in der Emitterfolgeschaltung seinen Zustand von EIN in AUS ändert, dadurch gekennzeichnet, daß der Entladungsweg (I, Ia) zwischen der Basis des Ausgangsstufentransistors (Q5) und dem Kollektor eines der Transistoren (Q2) in dem Differentialverstärker (DIF) verbunden ist und daß ein Stromschalter (D2, D3, D4) mit dem Entladungsweg (Ia) gekoppelt ist, um den Entladungsweg (Ia) abzuschneiden, wenn die Spannung zwischen der Basis und dem Emitter des Ausgangsstufentransistors (Q5) gleich oder kleiner als die Schwellwertspannung zur Einschaltung des Ausgangsstufentransistors (Q5) ist (Figur 5).

2. Leitungstreiberschaltung nach Anspruch 1, bei welcher der Stromschalter zwei Dioden (D3 und D4) umfaßt. die in Reihe in dem Entladungsweg (Ia) liegen, und eine Diode (D2), welche zwischen einer Erdleitung und dem Kollektor des genannten einen Transistors (Q2) in dem Differentialverstärker (DIF) angeschlossen ist.

3. Leitungstreiberschaltung nach Anspruch 1 oder 2, bei welcher die Leitungstreiberschaltung ferner einen Treibertransistor (Q3) zum Treiben des Emitterfolgers (Q4, Q5) in Abhängigkeit vom Einschalten oder Ausschalten des anderen der Transistoren (Q1) des Differentialverstärkers (DIF) umfaßt.

4. Leitungstreiberschaltung nach Anspruch 3, bei welcher der genannte eine Transistor des Differentialverstärkers (DIF) der zweite Transistor (Q2) und der andere Transistor des Differentialverstärkers der erste Transistor (Q1) ist.

## Revendications

1. Circuit d'attaque de ligne comprenant un amplificateur différentiel (DIF) comportant un premier transistor (Q2) pour recevoir un signal d'entrée et un second transistor (Q/) pour recevoir un signal de référence, les premier et second transistors étant exclusivement rendus conducteurs et bloqués en réponse à la tension du signal d'entrée, un étage de sortie comportant des transistors (Q4 et Q5) connectés selon une configuration à émetteur suiveur et dans lequel le transistor d'étage de sortie (Q5) fournit un signal de sortie de haute tension ou de basse tension en réponse à la tension de sortie de l'amplificateur différentiel (DIF), et un chemin de décharge (I, Ia) pour tirer les charges accumulées à la base du transistor d'étage de sortie (Q5) de l'étage à émetteur suiveur quand le transistor d'étage de sortie (Q5) de l'étage à émetteur suiveur passe de l'état conducteur à l'état bloqué, caractérisé en ce que le chemin de décharge (I, Ia) est connecté entre la base du transistor d'étage de sortie (Q5) et le collecteur d'un des transistors (Q2) de l'amplificateur différentiel (DIF) et en ce qu'un commutateur de courant (D2, D3, D4) est couplé au chemin de décharge (Ia), pour couper le chemin de décharge (Ia) quand la tension entre la base et l'émetteur du transistor d'étage de sortie (Q5) est égale ou inférieure à la tension de seuil servant à rendre conducteur le transistor d'étage de sortie (Q5) (Figure 5).

2. Circuit d'attaque de ligne selon la revendication 1, caractérisé en ce que le commutateur de courant comprend deux diodes (D3 et D4) connectées en série dans le chemin de décharge (Ia) et une diode (D2) connectée entre une ligne de masse et le collecteur du transistor (Q2) des transistors de l'amplificateur différentiel (DIF).

3. Circuit d'attaque de ligne selon l'une quelconque des revendications 1 et 2, caractérisé en ce qu'il comprend aussi un transistor d'excitation (Q3) pour exciter l'étage à émetteur suiveur (Q4, Q5) en réponse à la mise à l'état conducteur ou à l'état bloqué de l'autre transistor (Q1) des transistors de l'amplificateur différentiel (DIF).

4. Circuit d'attaque de ligne selon la revendication 3, caractérisé en ce que ledit transistor des transistors de l'amplificateur différentiel (DIF) est le second transistor (Q2) et ledit autre transistor des transistors de l'amplificateur différentiel est le premier transistor (Q1).

Fig. 1

Fig. 2

# Fig. 3

# Fig. 4

*Fig. 5*